# EUROPEAN PATENT APPLICATION

(11) **EP 3 605 114 A1**
(43) Date of publication of application: **05.02.2020**
(21) Application number: 19189121.7
(22) Date of filing: 30.07.2019
(51) Int. Cl.: G01R 15/18, G01R 15/20, G01R 19/00, G01R 33/00, G01R 33/02

(54) **CURRENT SENSOR**

(30) Priority: 31.07.2018 JP 2018143653
(71) Applicant: YAZAKI CORPORATION, Minato-ku, Tokyo 108-8333 (JP)
(72) Inventor: ONO, Chihiro, Susono-shi, Shizuoka 410-1194 (JP); SYOUDA, Takahiro, Susono-shi, Shizuoka 410-1194 (JP)
(74) Representative: Grünecker Patent- und Rechtsanwälte PartG mbB

(57) **Abstract**

A current sensor which can cancel an effect of a varying external magnetic field at a low cost is provided. A current sensor includes a magnetic field detecting element configured to detect a magnetic field generated due to a current flowing through a bus bar. An induced current is generated in a first coil due to an external magnetic field generated around the magnetic field detecting element. A second coil is connected to the first coil and configured to generate, upon flow of the induced current, a magnetic field that cancels the external magnetic field generated around the magnetic field detecting element.

## Description

### Technical Field

The present invention relates to a current sensor.

### Background

A current sensor using a magnetic field detecting element is conventionally known. This current sensor detects, using the magnetic field detecting element, a magnetic field generated by a current flowing through an object to be measured, and calculates a current value from the magnetic field detected by the magnetic field detecting element.

The above-described current sensor may be affected by an external magnetic field (a magnetic field other than the magnetic field generated by the current flowing through the object to be measured), causing an error in the current sensor. To address this, there has been proposed a current sensor provided with a shield for blocking an external magnetic field arranged around a magnetic field detecting element (refer to Patent Document 1 listed below). However, there is a drawback that the use of the shield causes an increase in size and cost.

There has also been proposed a current sensor including magnetic field detecting elements arranged at positions where absolute values of the external magnetic field are the same and polarities are opposite, respectively, and configured to detect a difference in outputs from these two magnetic field detecting elements to cancel an effect of the external magnetic field (refer to Patent Document 2). However, there is a drawback that this is only effective when the external magnetic field is uniform and thus an effect of a varying external magnetic field cannot be cancelled.

### Prior Art Document

### Patent Document

Utility Model Document 1: JPH 5-25369 U
Patent Document 2: JP 2002-243766 A

### Summary of the Invention

In view of the above-described background, an object of the present invention is to provide a current sensor which can cancel an effect of a varying external magnetic field at a low cost. Solution to Problem

According to one embodiment of the present invention, a current sensor includes a magnetic field detecting element configured to detect a magnetic field generated by a current flowing through an object to be measured, a first coil in which an induced current is generated due to an external magnetic field varying around the magnetic field detecting element, and a second coil connected to the first coil and configured to generate, upon flow of the induced current, a magnetic field that cancels the external magnetic field varying around the magnetic field detecting element.

Further, the magnetic field detecting element may be arranged in vicinity of the second coil.

Further, the magnetic field detecting element may be arranged inside the second coil.

Further, the magnetic field detecting element may be arranged outside the second coil along the magnetic field generated by the second coil.

### Advantageous Effects of the Invention

According to the embodiments described above, a current sensor which can cancel an effect of a varying external magnetic field at a low cost can be provided.

### Brief Description of the Drawings

FIG. 1 is a diagram showing a current sensor according to a first embodiment of the present invention;
FIG. 2 is a diagram showing a current sensor according to a second embodiment of the present invention; and
FIG. 3 is a diagram showing a current sensor according to a third embodiment of the present invention;

### Detailed Description of the Exemplary Embodiments

### <First Embodiment>

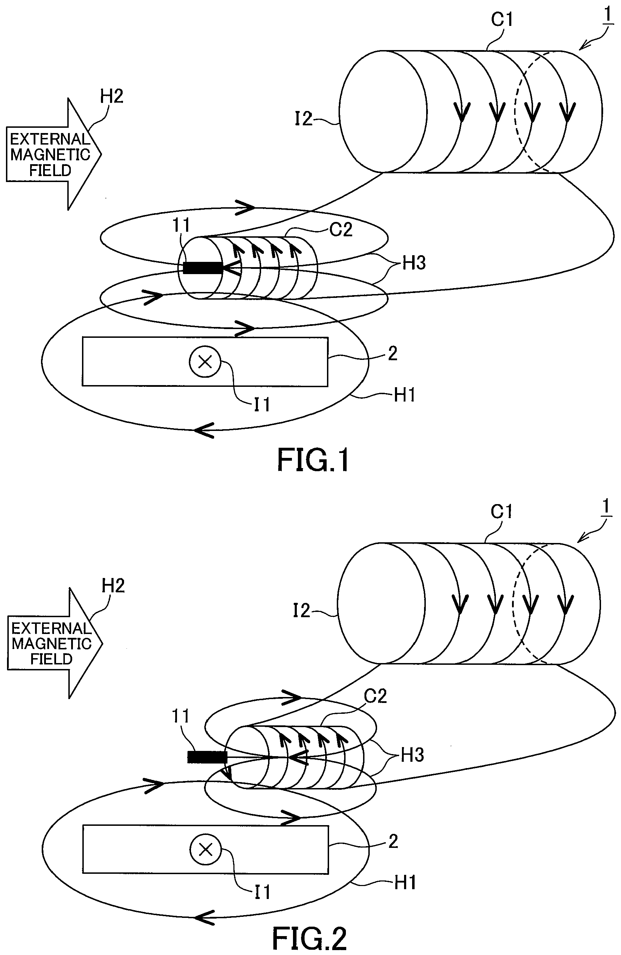

In the following, a first embodiment of the present invention will be explained with reference to FIG. 1. A current sensor 1 shown in FIG. 1 is a sensor configured to detect a current I1 flowing through a bus bar (an object to be measured) 2. In the drawing, the current I1 flows in the bus bar 2 in a direction perpendicular to a plane of a paper, and a magnetic field H1 is generated due to this current I1. The magnetic field H1 is generated around an axis corresponding to the direction in which the current I1 flows (i.e., the direction perpendicular to the plane of the paper).

The current sensor 1 includes a magnetic field detecting element 11, a first coil C1 and a second coil C2. The magnetic field detecting element 11 is an element that outputs a voltage according to a magnitude of a magnetic field, and is arranged around the bus bar 2 (within a range into which the magnetic field H1 is inputted or penetrates).

The output of the magnetic field detecting element 11 may be affected by an external magnetic field H2 (i.e., a magnetic field other than the magnetic field H1 generated by the current I1 flowing through the bus bar 2), possibly lowering the detection accuracy. Thus, in this embodiment, in order to cancel the effect of the external magnetic field H2, the first coil C1 and the second coil C2 are arranged around the magnetic field detecting element 11.

The first coil C1 is arranged around the magnetic field detecting element 11, and an induced current I2 is generated due to a change (variation) in the external magnetic field H2 generated around the magnetic field detecting element 11. The first coil C1 is wound in a spiral fashion, and a central axis of the first coil C1 is arranged parallel to a direction of the magnetic field H1 generated at the arrangement position of the magnetic field detecting element 11.

In this embodiment, in the arrangement position of the magnetic field detecting element 11, the direction of the magnetic field H1 is parallel to a right-left direction with respect to the plane of the paper, thus the first coil C1 is arranged such that its central axis is parallel to the right-left direction. As such, when the external magnetic field H2 in the right-left direction is generated, the induced current I2 according to a magnitude of the change in the external magnetic field H2 is generated in the first coil C1.

The second coil C2 is connected to the first coil C1 and is configured to generate, upon the flow of the induced current 12, a magnetic field H3 that cancels the external magnetic field H2 generated around the magnetic field detecting element 11. The second coil C2 is wound in a spiral fashion, and both ends of the second coil C2 are connected to both ends of the first coil C1. As such, the induced current I2 generated in the first coil C1 flows through the second coil C2.

The magnetic field detecting element 11 is arranged in vicinity of the second coil C2. In the first embodiment, the magnetic field detecting element 11 is arranged inside this second coil C2. Thus, the second coil C2 is arranged so as to generate, upon the flow of the induced current 12, the magnetic field H3 opposite of the external magnetic field H2, inside the second coil C2. That is, the first coil C1 is opposite in the winding direction to the second coil C2. In addition, a diameter or number of turns of the first and second coils C1, C2 are adjusted such that a magnitude of the magnetic field H3 and a magnitude of the external magnetic field H2 are equal.

Next, a principle of current detection of the current sensor 1 configured as described above will be explained. When the current I1 flows through the bus bar 2, the magnetic field H1 according to a magnitude of the current I1 is generated around the bus bar 2. In this embodiment, the current I1 flows in the direction perpendicular to the plane of the paper from a front side to a back side. At this time, the magnetic field H1 is generated in a clockwise direction around the bus bar 2, and the magnetic field H1 heading from the left side to the right side is inputted to the magnetic field detecting element 11.

The following will explain a case where the external magnetic field H2 (alternate current) with a varying magnitude of the magnetic field and a varying direction (polarity) of the magnetic field are generated at this time. Now, when the external magnetic field H2 heading from the left side to the right side is generated, the induced current I2 is generated in the first coil C1 in the clockwise direction with respect to the central axis, as shown in FIG. 1. This generated induced current I2 flows through the second coil C2.

The induced current I2 flowing through the second coil C2 flows in a counterclockwise direction with respect to the central axis, contrary to the first coil C1. Then, due to the flow of the induced current 12, the magnetic field H3 in the direction from the right side to the left side, i.e., in the direction opposite to the direction of the external magnetic field H2, is generated inside the second coil C2. The diameter and the number of turns of the first and second coils C1, C2 are adjusted such that this magnetic field H3 has the same magnitude with the external magnetic field H2. Consequently, the external magnetic field H2 around the magnetic field detecting element 11 is cancelled by the magnetic field H3, thereby the effect of the external magnetic field H2 can be cancelled.

Further, when the external magnetic field H2 varies and increases, the induced current I2 increases, and the magnetic field H3 increases. When the external magnetic field H2 varies and decreases, the induced current I2 decreases, and the magnetic field H3 decreases. Thus, the magnetic field H3 having the same magnitude as the external magnetic field H2 is always generated inside the second coil C2, thereby the effect of the varying external magnetic field H2 can be cancelled.

On the other hand, when the external magnetic field H2 heading from the right side to the left side is generated, the induced current I2 is generated in the first coil C1 in the counterclockwise direction with respect to the central axis. This generated induced current I2 flows through the second coil C2. The induced current I2 flowing through the second coil C2 flows in the clockwise direction with respect to the central axis, contrary to the first coil C1. Then, due to the flow of the induced current 12, the magnetic field H3 in the direction from the left side to the right side, i.e., in the direction opposite to the direction of the external magnetic field H2, is generated inside the second coil C2. Consequently, even if the direction of the external magnetic field H2 varies, the external magnetic field H2 around the magnetic field detecting element 11 is cancelled by the magnetic field H3, thereby the effect of the external magnetic field H2 can be cancelled.

According to the first embodiment described above, the current sensor 1 configured to cancel the effect of the varying external magnetic field H2 without use of a shield or a plurality of magnetic field detecting elements as described above can be provided at a low cost. Further, a control system such as the one for a calculating process is not required, and also, there is no time delay from the generation of the external magnetic field H2 until the cancelling.

### <Second Embodiment>

Next, a second embodiment of the present invention will be explained with reference to FIG. 2. The second embodiment differs from the first embodiment mainly in the arrangement position of the magnetic field detecting element 11. In the second embodiment, the magnetic field detecting element 11 is arranged outside the second coil C2 along a magnetic field generated by the second coil C2. Further, in the second embodiment, the magnetic field detecting element 11 and the second coil C2 are opposedly-arranged along the axial direction of the second coil C2 with a space between each other. It is noted that the direction of the magnetic field H3 in the arrangement position of the second embodiment shown in FIG. 2 is the same as the direction of the magnetic field H3 inside the second coil C2.

As in the case with the first embodiment, in this case the induced current I2 is generated in the first coil C1 upon the change in the external magnetic field H2, and this induced current I2 flows through the second coil C2. Then , due to the induced current I2 flowing through the second coil C2, the magnetic field H3 having the opposite direction to the external magnetic field H2 is generated at the arrangement position of the magnetic field detecting element 11, thereby cancelling the external magnetic field H2.

### <Third Embodiment>

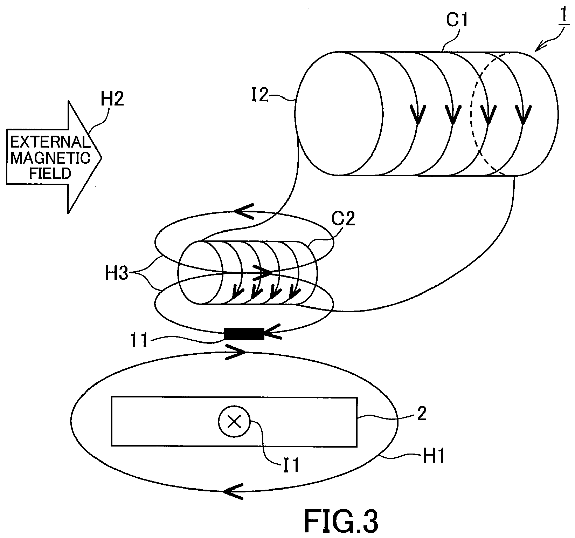

Next, a third embodiment of the present invention will be explained with reference to FIG. 3. The third embodiment differs from the first embodiment mainly in the arrangement position of the magnetic field detecting element 11. In the third embodiment, the magnetic field detecting element 11 is arranged outside the second coil C2 along a magnetic field generated by the second coil C2. Further, in the third embodiment, the magnetic field detecting element 11 and the second coil C2 are opposedly-arranged along a radial direction of the second coil C2 with a space between each other. It is noted that the direction of the magnetic field H3 in the arrangement position of the third embodiment shown in FIG. 3 is opposite to the direction of the magnetic field H3 inside the second coil C2.

Thus, unlike the first and second embodiments, in the third embodiment, the winding direction is the same in the first and second coils C1, C2.

Next, a principle of current detection of the current sensor 1 configured as described above will be explained. When the current I1 flows through the bus bar 2, the magnetic field H1 according to a magnitude of the current I1 is generated around the bus bar 2. In this embodiment, the current I1 flows in the direction perpendicular to the plane of the paper from the front side to the back side. At this time, the magnetic field H1 is generated in the clockwise direction around the bus bar 2, and the magnetic field H1 heading from the left side to the right side is inputted to the magnetic field detecting element 11.

The following will explain a case where the external magnetic field H2 (alternate current) with a varying magnitude of the magnetic field and a varying direction (polarity) of the magnetic field are generated at this time. Now, when the external magnetic field H2 heading from the left side to the right side is generated, the induced current I2 is generated in the first coil C1 in the clockwise direction with respect to the central axis, as shown in FIG. 3. This generated induced current I2 flows through the second coil C2.

In the third embodiment, the induced current I2 flowing through the second coil C2 flows in the clockwise direction with respect to the central axis, as in the first coil C1. Then, due to the induced current I2 flowing through the second coil C2, the magnetic field H3 in the direction from the right side to the left side, i.e., in the direction opposite to the direction of the external magnetic field H2, is generated at the arrangement position of the magnetic field detecting element 11. Consequently, the external magnetic field H2 around the magnetic field detecting element 11 is cancelled by the magnetic field H3, thereby the effect of the external magnetic field H2 can be cancelled.

On the other hand, when the external magnetic field H2 heading from the right side to the left side is generated, the induced current I2 is generated in the first coil C1 in the counterclockwise direction with respect to the central axis. This generated induced current I2 flows through the second coil C2. The induced current I2 flowing through the second coil C2 flows in the counterclockwise direction with respect to the central axis, as in the first coil C1. Then, due to the induced current I2 flowing through the second coil C2, the magnetic field H3 in the direction from the left side to the right side, i.e., in the direction opposite to the direction of the external magnetic field H2, is generated at the arrangement position of the magnetic field detecting element 11. Consequently, even if the direction of the external magnetic field H2 varies, the external magnetic field H2 around the magnetic field detecting element 11 is cancelled by the magnetic field H3, thereby the effect of the external magnetic field H2 can be cancelled.

The present invention is not limited to the above-described embodiments. That is, various modifications can be made and implemented without departing from the scope of the present invention.

### List of Reference Signs

- 1: current sensor
- 2: bus bar (object to be measured)
- C1: first coil
- C2: second coil
- 11: magnetic field detecting element
- I2: induced current
- I1: current

## Claims

1. A current sensor comprising:
a magnetic field detecting element configured to detect a magnetic field generated by a current flowing through an object to be measured;
a first coil in which an induced current is generated due to an external magnetic field varying around the magnetic field detecting element; and
a second coil connected to the first coil and configured to generate, upon flow of the induced current, a magnetic field that cancels the external magnetic field varying around the magnetic field detecting element.

2. The current sensor according to claim 1, wherein
the magnetic field detecting element is arranged in vicinity of the second coil.

3. The current sensor according to claim 1, wherein
the magnetic field detecting element is arranged inside the second coil.

4. The current sensor according to claim 1, wherein
the magnetic field detecting element is arranged outside the second coil along the magnetic field generated by the second coil.
